# EUROPÄISCHE PATENTSCHRIFT

(11) **EP 4 508 442 B1**
(45) Veröffentlichungstag und Bekanntmachung des Hinweises auf die Patenterteilung: **21.10.2026**
(21) Anmeldenummer: 23712264.3
(22) Anmeldetag: 20.03.2023
(51) Int. Cl.: G01R 1/20, G01R 1/30, G01R 31/54

(54) **ÜBERWACHUNGSVORRICHTUNG FÜR HOCHDYNAMISCHE STRÖME, INSBESONDERE FÜR DIE ÜBERWACHUNG VON BAHNSTRÖMEN**
MONITORING DEVICE FOR HIGHLY DYNAMIC CURRENTS, IN PARTICULAR FOR MONITORING TRACTION CURRENTS
DISPOSITIF DE SURVEILLANCE POUR COURANTS HAUTEMENT DYNAMIQUES, EN PARTICULIER POUR LA SURVEILLANCE DE COURANTS DE TRACTION

(30) Priorität: 12.04.2022 DE 102022203697
(43) Veröffentlichungstag der Anmeldung: 19.02.2025
(73) Patentinhaber: Knick Elektronische Messgeräte GmbH & Co. KG, 14163 Berlin (DE)
(72) Erfinder: SCHWEIZER, Lars, 12307 Berlin (DE); HÖFEMANN, Rayk, 38685 Langelsheim (DE); HAHN, Torsten, 14167 Berlin (DE)
(74) Vertreter: Rau, Schneck & Hübner Patentanwälte Rechtsanwälte PartGmbB
(86) Internationale Anmeldenummer: PCT/EP2023/057071
(87) Internationale Veröffentlichungsnummer: WO 2023/198407

(56) Entgegenhaltungen:
- US-A1- 2010 045 263
- US-A1- 2018 080 960

## Beschreibung

Die Erfindung betrifft eine Überwachungsvorrichtung für hochdynamische Ströme, insbesondere für die Überwachung von Bahnströmen, Antriebsströmen von Anlagen oder dergleichen, mit den im Oberbegriff des Patentanspruches 1 angegebenen Merkmalen.

Eine Überwachungsvorrichtung zum Bestimmen niedriger Ströme im Bereich von 0,3 µA bis 3 mA, beispielsweise zum Betreiben eines Mikroprozessors, ist bekannt aus der US 2018/0080960 A1.

Die vorliegende Erfindung befasst sich hingegen mit besonders robustem Equipment zur Messung von energietechnischen Strömen, die sich in einem sehr großen Bereich auch innerhalb kurzer Zeitspannen ändern können. Das betrifft beispielsweise elektromotorische Antriebe für industrielle Einrichtungen, wo Elektromotoren und die zu beschleunigenden Massen zu großen Anlaufströmen führen oder bei denen Blockaden im Antriebsstrang zu großen Drehmomenten bzw. letztlich sehr großen Motorströmen führen. Als Beispiel für solche Industrieeinrichtungen sind große Mahlwerke oder Walzantriebe in der Stahlproduktion zu nennen. Insbesondere jedoch im Bereich der Energieversorgung elektrischer Bahnen sind die Stromamplituden besonders dynamisch. In den hierfür speziell errichteten sogenannten Unterwerken der Bahnstromversorgung ist es daher besonders wichtig, eine zuverlässige und sichere Stromversorgung der Bahnlinien sicherzustellen.

Oftmals verlaufen elektrifizierte Bahnlinien in Städten sowohl unterirdisch als auch oberirdisch. Die Versorgung der elektrischen Schienenfahrzeuge mit der erforderlichen Antriebsenergie erfolgt zumeist über Oberleitungen oder über sogenannten Stromschienen. Der Rückstrom des Schienenfahrzeugs erfolgt über die metallischen Fahrgleise.

Es ist üblich, im öffentlichen Personennahverkehr eher geringe Spannungen von zum Beispiel nominal 750 V oder nominal 1500 V DC in die Oberleitungen bzw. in die Stromschiene einzuspeisen. Bei diesen eher geringen Spannungen können daher je nach benötigter Antriebsleistung Ströme bis nominal 4000 Ampere oder mehr im normalen Betriebsfall auftreten. Daher sind sogenannte Unterwerke in regelmäßigen Abständen längs der Bahnstrecke erforderlich, damit jeweils wieder erneut Energie eingespeist werden kann. Diese Unterwerke haben im Allgemeinen einen Abstand von wenigen Kilometern zueinander um die ohmschen Verluste in den Oberleitungen, Stromschienen und Fahrgleisen immer wieder auszugleichen.

Mitunter fahren auch mehrere Schienenfahrzeuge auf dem gleichen Streckenabschnitt und diese können sich in jeweils unterschiedlichen, aber auch gleichen Fahrsituationen, wie Beschleunigung, Fahrt oder Abbremsung oder Stillstand befinden. Es ist daher nachvollziehbar, dass der Strom in der Versorgungsleitung einen stark zeitabhängigen Verlauf und einen gewissen, vom Fahrzeugort abhängigen Verlauf hat, der sich innerhalb von Sekundenbruchteilen ändern kann.

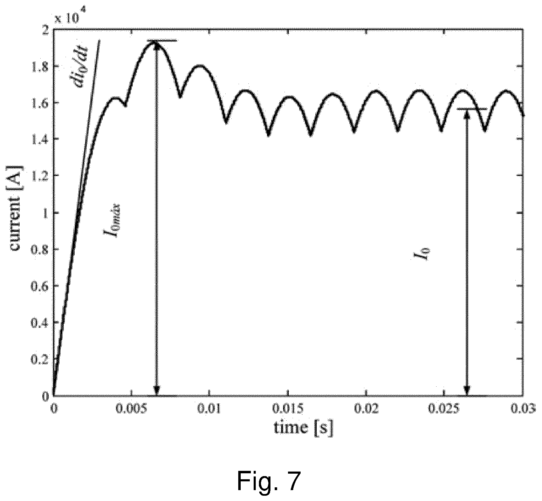

Hinzu kommt, dass elektrifizierte Bahnlinien im Vergleich zu anderen Stromtrassen einem höheren Risiko von Kurzschlüssen ausgesetzt sind, beispielsweise durch Tierschäden, Baumschäden, Schäden an Schienenfahrzeugen, Blitzeinwirkung etc. Eine solche Störung führt je nach der Entfernung des Kurzschlusses vom Unterwerk zu teils sehr steilen Stromanstiegen, die ein Vielfaches des normalen Fahrstromes betragen können. Figur 7 zeigt den bekannten, möglichen Zeitverlauf des Stroms bei einem Kurzschluss, bei dem ein Strom von bis zu 19000 Ampere innerhalb von ca. 7 Millisekunden erreicht werden kann. Dieser Spitzenwert ist mehr als das Vierfache des regulären Fahrstromes.

Als besonders robuste sowie auch zuverlässige, kurzschlussfeste und Langzeit-genaue Stromsensoren haben sich seit vielen Jahrzehnten Shuntwiderstände für den Kiloampere-Bereich etabliert. Eine europäische Norm definiert Fehlerströme aufgrund von Störungen von bis zu 125 Kiloampere. Damit Kurzschlüsse sicher von regulären Stromverläufen unterschieden werden können, kommen Protection Relays bzw. Schutzgeräte genannte Vorrichtungen zum Einsatz, die insbesondere den zeitlichen Stromverlauf analysieren und im Fall eines erkannten Kurzschlusses einen Stromunterbrecher bzw. Leistungsschalter zum Unterbrechen des Stromkreises veranlassen. Dies muss innerhalb weniger Millisekunden geschehen, bevor der Strom auf zu hohe Werte angestiegen ist und diese hohen Werte für eine zu lange Zeit aufweist und es zu Schäden im Unterwerk und dem Stromunterbrecher und letztlich auch den Versorgungsleitungen kommt. Zu beachten ist außerdem die durch Wärmewirkung und Lichtbogenerscheinungen am Orte des Kurzschlusses entstehende Brandgefahr, was in unterirdischen Bahnhöfen und Tunneln besonders problematisch ist. Weil die eingesetzten Shuntwiderstände auf hohem Potenzial gegenüber Erde liegen, werden potenzialtrennende Messverstärker eingesetzt. Diese Messverstärker übernehmen die Verstärkung der nur wenige Millivolt betragenden Spannungen, die an den Shuntwiderständen abfallen, und geben die verstärkten Signale potenzialgetrennt an deren Ausgang als Strom- oder Spannungssignal wieder aus. Sie besitzen durch ein internes isolierendes Signal- und Energie-übertragungssystem damit die Fähigkeit, gefährlich hohe Spannungen, die am Shuntwiderstand anliegen, vom Messsignalausgang und auch von dem Energieversorgungsanschluss fernzuhalten. Infolgedessen verhindern sie dadurch nicht nur mögliche Personenschäden durch zu hohe Körperströme, sondern damit auch Messfehler durch unerwünschte Fehlerströme sowie Schäden zum Beispiel an dem Schutzgerät.

Ein unerwünschter Stillstand eines Schienenfahrzeuges stellt eine ernst zu nehmende Gefahr dar, insbesondere auf Streckenabschnitten außerhalb von Bahnhöfen, insbesondere in Tunneln oder unterirdischen Bahntrassen ist z.B. eine sichere Evakuierung von Personen besonders schwierig.

Aufgrund der zunehmenden Anforderungen an die Zuverlässigkeit insbesondere der Bahnstromversorgung muss auch der Zustand bzw. Verschleiß der Stromunterbrecher bzw. Leistungsschalter überwacht werden. In diesem Zusammenhang beschreibt die EP 2 328 159 A1 die Möglichkeit, mit Hilfe von Strommesswerten Aussagen über den Verschleiß von Leistungsschaltern zu treffen, um eine passgenaue Wartung von solchen Stromunterbrechern durchführen zu können.

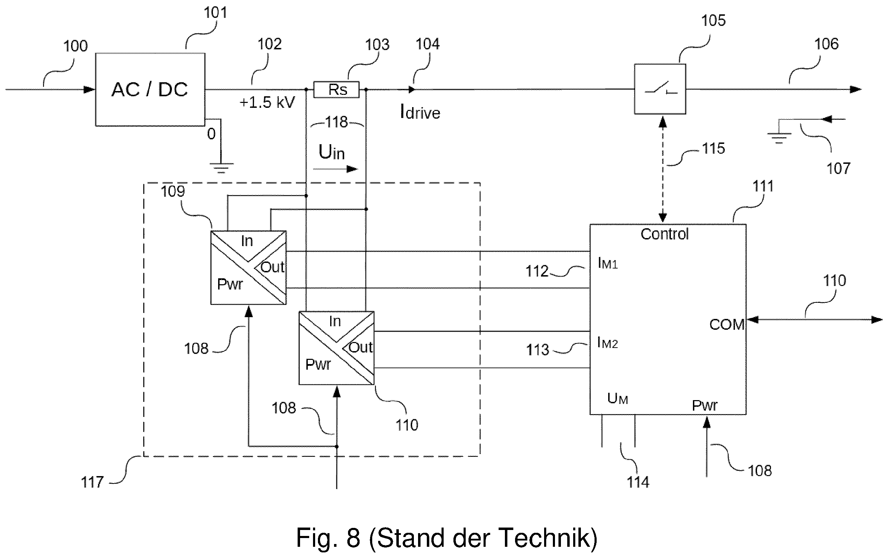

Figur 8 zeigt eine typische gattungsgemäße Überwachungsvorrichtung, wie sie beispielsweise in einem DC-Unterwerk für die Versorgung einer Bahnstrecke vorzufinden ist und einen Shuntwiderstand 103 in der den zu überwachenden Strom I_{drive} führenden Versorgungsleitung 104, eine den Spannungsabfall Uᵢₙ am Shuntwiderstand 103 eingangsseitig aufnehmende Messverstärkerschaltung 117 mit einem Gesamt-Dynamikbereich, der Regelbetriebsströme und Störströme abdeckt, und ein das Ausgangssignal (I_{M1}, I_{M2}) der Messverstärkerschaltung 117 aufnehmendes Schutzgerät 111 zum Erfassen von Regelbetriebs- und Störströmen.

Im einzelnen erfolgt die Versorgung eines DC-Unterwerks z.B. aus dem mehrphasigen AC- Mittelspannungsnetz bzw. AC-Hochspannungsnetz über einen Transformator, der die Spannung genügend reduziert. Diese reduzierte mehrphasige AC-Spannung wird über die Zuführleitung 100 einem elektronischen und ggf. geregelten Leistungsgleichrichter 101 zugeführt, der dann einen oder mehrere DC-Ausgänge 102 mit z.B. einer Ausgangsspannung von nominal + 1500 V DC besitzt. Dieser Ausgang 102 kann über den Leistungs-Shuntwiderstand 103 den erforderlichen Strom I_{drive} über die Leitung 104 an den Leistungsschalter bzw. Stromunterbrecher 105 liefern. Der Shuntwiderstand 103 kann auch hinter dem Stromunterbrecher 105 angeordnet sein.

Der Strom I_{drive} kann in normalen Fahrsituationen Werte von bis zu mehreren tausend Ampere, beispielsweise 2000 A annehmen. Die damit zur Verfügung gestellte Leistung wäre also in diesem Fall nominal 3 MW. Der Stromunterbrecher 105 leitet im geschlossenen Zustand dann diese Energie über die Leitung 106 an die Oberleitung bzw. Stromschiene weiter. Der Rückstrom vom Schienenfahrzeug fließt über die Fahrschienen in den oftmals geerdeten Punkt 107, der auch mit dem Leistungsgleichrichter 101 verbunden ist (0 Volt Anschluss von 101).

Der Leistungsschalter 105 wird elektrisch vom sogenannten Schutzgerät 111 (Protection Relay) über die Steuerleitungen 115 gesteuert, die mit dem Anschluss Control verbunden sind. Diese Steuerleitungen 115 melden auch die jeweils herrschende Schalterstellung an das Schutzgerät 111 über den Anschluss Control zurück. Es sei noch erwähnt, dass der Leistungsschalter 105 üblicherweise auch eigene elektromagnetische Auslösemittel besitzt, die bei sehr großen Überströmen den Leistungsschalter selbsttätig öffnen, also ohne Öffnungsbefehl vom Schutzgerät 111 den Stromkreis unterbrechen. Dies bringt zusätzliche Sicherheit im Falle eines Fehlers des Schutzgerätes.

Das Schutzgerät 111 besitzt die Messeingänge I_{M1}, I_{M2} und U_{M} für die Messgrößen des Fahrstromes I_{drive} (aufgeteilt in 2 Messkanäle I_{M1} und I_{M2}) und die Fahrspannung am Einspeisepunkt, die über einen Spannungsmessumformer (nicht eingezeichnet) von der Leitung 104 abgenommen und dem Messeingang U_{M} zugeführt wird. Das Schutzgerät besitzt noch einen Kommunikationsanschluss COM, der mit einem in Unterwerken üblichen Kommunikationsprotokoll Ereignisse, Zustände, Messwerte etc. über eine Datenleitung 110, z.B. einer Art Ethernet-Leitung, an eine Leitwarte melden kann und über den auch das Schutzgerät ggf. von einer Leitwarte aus parametriert werden kann. Außerdem besitzen sowohl die Messverstärker 109 und 110 sowie das Schutzgerät 111 jeweils einen Anschluss 108 für die Zufuhr von Hilfsenergie, beispielsweise 24 V DC oder 110 V DC.

Die Shuntspannung Uᵢₙ wird über passende Leitungen 118 an die Eingänge der potenzialtrennenden Messverstärker 109 und 110 geführt. Der erste Messverstärker 109 bildet die Shuntspannung Uᵢₙ auf einen Ausgangsstrom Iₒᵤₜ₁ ab und liefert diesen Strom an den Messeingang I_{M1}. Der zweite Messverstärker 110 bildet die Shuntspannung Uᵢₙ auf einen Ausgangsstrom Iₒᵤₜ₂ ab und liefert diesen Strom an den Messeingang I_{M2}. Übliche Maximalwerte solcher Signalströme können bei z.B. 20 mA (Standardsignal der Automatisierungstechnik) liegen. Die Shuntspannung Uᵢₙ ist proportional zu I_{drive}, übliche Werte sind beispielsweise 60 mV bei einem Strom von 4000 A, was einem Shuntwiderstand von 15 µOhm entspricht.

Um die Eigenschaften des Messverstärkers 109 zu definieren, lässt sich eine lineare Transferfunktion Iₒᵤₜ₁ = tf₁(Uᵢₙ) angeben: ${tf}_{1} \left({U}_{in}\right) = {a}_{0} + {a}_{1} * {U}_{in} = {I}_{out 1}$ mit a₁ = dIₒᵤₜ₁/dUᵢₙ, womit der Koeffizient a₁ gleichbedeutend mit der Steigung der Transferfunktion tf₁ ist.

Um die Eigenschaften des Messverstärkers 110 zu definieren, lässt sich eine lineare Transferfunktion Iₒᵤₜ₂ = tf₂(Uᵢₙ) angeben: ${tf}_{2} \left({U}_{in}\right) = {b}_{0} + {b}_{1} * {U}_{in} = {I}_{out 2}$ mit b₁ = dIₒᵤₜ₂/dUᵢₙ, womit der Koeffizient b₁ gleichbedeutend mit der Steigung dieser Transferfunktion ist.

Eine übliche Auslegung für die beiden Transferfunktionen ist a₁ = k * b₁, wobei k = 10 (Beispiel).

Die Koeffizienten a₀ bzw. b₀ der Transferfunktionen tf₁ und tf₂ bestimmen den Ausgangswert der Messverstärker 109 bzw. 110 bei der Eingangsspannung Uᵢₙ=0. Diese Koeffizienten sind also bei Messverstärkern mit einem sogenannten Live-Zero-Stromausgang (z.B. 4...20 mA) dann größer als Null, bei einem Dead-Zero-Ausgang (z.B. 0...20 mA) sind sie gleich Null. Die Ausgänge der Messverstärker 109 und 110 können auch als Spannungsausgänge ausgebildet sein.

Die Verwendung zweier Messkanäle ermöglicht es, dass beispielsweise mit dem Messkanal I_{M1} der reguläre Fahrstrom (z.B. maximal 4000 A) und mit dem Messkanal I_{M2} der k-fache Fahrstrom abgebildet werden können, (z.B. maximal 40000 A). Dabei ist vorauszusetzen, dass die Messkanäle (Messeingänge) des Schutzgerätes 111 jeweils den gleichen Bereich der von den Messverstärkern ausgegebenen Signalströme an den Eingängen I_{M1} und I_{M2} verarbeiten. Ebenso ist der jeweils von den Messverstärkern 109 und 110 ausgebbare Maximalstrom auf den gleichen Wert limitiert. Das bedeutet, dass im Falle eines Überstromereignisses, also bei Werten I_{drive} z.B. ab größer als 4000 A der Messverstärker 109 einen gleichbleibenden Maximalwert liefert, bzw. der Messeingang I_{M1} übersteuert wird, in jedem Falle also keine Aussage mehr über die tatsächliche Höhe des Stromes I_{drive} mit diesem Messkanal mehr möglich ist. Genau für diesen Fall kommt der Messkanal I_{M2} zum Zuge, der Werte größer als 4000 Ampere noch linear abbilden kann. Es ist dann Aufgabe des Schutzgerätes 111, die Informationen beider Messkanäle passend auszuwerten, um Regelbetrieb- und Störströme zu erfassen und gegebenenfalls entsprechende Aktionen daraus abzuleiten, wie eine Auslösung des Stromunterbrechers 105.

Diese aus dem Stand der Technik bekannte Aufteilung auf zwei Messkanäle bietet die Möglichkeit, sowohl den Fahrstrom als auch den Kurzschlussstrom bzw. Störstrom mit guter Auflösung und geringem Rauschen abzubilden. Das Schutzgerät 111 arbeitet üblicherweise mit digitaler Signalverarbeitung. Nachdem die elektrischen Signale der Messkanäle I_{M1}, I_{M2} und U_{M} (Anschluss 114) im Schutzgerät 111 mit begrenzter zeitlicher und amplitudenmäßiger Auflösung digitalisiert wurden, bewerten Algorithmen die Messkanalinformationen und deren zeitlichen Verläufe um den Stromunterbrecher 105 situationsgerecht zu steuern. Dabei ermöglicht der zweite Messkanal I_{M2} auch bei sehr großen Werten für I_{drive} noch Aussagen über die Höhe des Kurzschlussstromes, was für die Ermittlung eines Wartungsbedarfs der Kontakte bzw. des Leistungsschalters insgesamt (z.B. Lichtbogenlöschkammer, elektrischer / mechanischer Stellantrieb etc.) wichtig ist. Selbstverständlich muss die jeweilige Transferfunktion der Messverstärker 109, 110 und die Zuordnung zum Messkanal dem Schutzgerät 111 "bekannt sein". Es sei schließlich erwähnt, dass an Stelle zweier einkanaliger Messverstärker auch ein zweikanaliger Messverstärker 117 verwendet werden kann. Ein solches Zweikanalgerät ist durch das gestrichelte Kästchen in Figur 8 also in einem gemeinsamen Gehäuse realisiert. Bei der beschriebenen Überwachungsvorrichtung gemäß dem Stand der Technik ist durch die zweikanalige Auslegung ein hoher apparativer Aufwand erkennbar. Dieser ist im Hinblick auf die Zuverlässigkeit und Wirtschaftlichkeit bekannter Überwachungsvorrichtungen von Nachteil. Dementsprechend liegt der Erfindung die Aufgabe zugrunde, eine gattungsgemäße Überwachungsvorrichtung bereitzustellen, die ohne relevante Einbu-ßen bei der Messqualität zur Vermeidung der genannten Nachteile konstruktiv einfacher ausgelegt ist.

Diese Aufgabe wird durch die Merkmale des Anspruchs 1 gelöst, welcher eine einkanalige Messverstärkerschaltung aufweist, die mit einem den Gesamt-Dynamikbereich der Eingangsspannung abbildenden Messverstärker und einer das Ausgangssignal des Messverstärkers aufnehmenden Kompressionsstufe mit mindestens zwei unterschiedlichen Transferfunktionen versehen ist, von denen eine erste Transferfunktion den Messbereich der Regelbetriebsströme hoch aufgelöst und von denen die zweite, die Dynamik der Eingangsspannung komprimierende Transferfunktion den Messbereich der Störströme niedriger aufgelöst in ein Ausgangssignal der Messverstärkerschaltung wandelt.

Das Auswertegerät kann ganz allgemein zum Beispiel durch klassische speicherprogrammierbare Steuerungen oder andere Mess- und Regelgeräte realisiert werden. Solche Auswertegeräte haben im Allgemeinen Anschlüsse zur Datenkommunikation und ggf. auch Ausgänge zur Steuerung von Aktoren, Relais, Umrichtern etc. Kennzeichnend für alle Auswertegeräte ist, dass sie Messeingänge besitzen, die nur einen begrenzten Dynamikbereich verarbeiten können. Es ist also für die Anwendung der erfindungsgemäßen Überwachungsvorrichtung nicht ausschlaggebend, ob letztlich ein Leistungsschalter bzw. Stromunterbrecher gesteuert wird. Es ist für viele industrielle oder infrastrukturelle Einrichtungen allgemein sehr sinnvoll und durch den geringen erfindungsbegründeten Aufwand auch attraktiv, den über die Messeingänge der Auswertegeräte erfassten Stromdynamikbereich erfindungsgemäß deutlich zu erweitern. Das ermöglicht z.B. erweiterte Diagnosefunktionen. Im Fall von Antriebssträngen kann bei Blockaden beispielsweise die erweiterte Dynamik eine Aussage über die mögliche Schädigung von Kupplungen, Wellen, Walzen, Lagern oder anderen mechanischen, elektrischen oder elektromechanischen Komponenten ermöglichen.

Es ist ersichtlich, dass für die Überwachungsvorrichtung nur noch ein vorzugsweise potenzialtrennender Messverstärker für die Shuntspannung Uᵢₙ erforderlich ist. Demzufolge benötigt auch das Auswertegerät nur noch einen Messkanal I_{M} für den Strom. Trotzdem können mit dieser stark reduzierten und dadurch deutlich preiswerteren Anordnung sowohl Regelbetriebsströme, wie der reguläre Betriebsstrom einer industriellen Anlage oder der Fahrstrom eines Bahnfahrzeuges, als auch Störströme, wie ein Kurzschlussstrom ausreichend genau vom Schutzgerät erfasst werden. Es können also ganz allgemein sehr dynamische Motorströme elektrischer Antriebsmotoren jedweder Art, wie in industriellen Einrichtungen oder Fahrzeugen überwacht werden. Das Auswertegerät muss dabei nur einen Strommesskanal besitzen.

Im Folgenden wird insbesondere die hochdynamische Überwachung von Strömen in der Energieversorgung elektrischer Bahnen als beispielhafter Anwendungsfall beschrieben. Die Anwendung der erfindungsmäßen Überwachungseinrichtung ist aber ausdrücklich nicht darauf beschränkt. Im Folgenden wird daher der auch der Begriff Auswertegerät als Oberbegriff verwendet, der auch ein Schutzgerät (Protection Relay) mit umfasst, wie es im abhängigen Anspruch 2 als bevorzugte Ausführungsform angegeben und zum Beispiel in der Bahnstromversorgung in Unterwerken für die Stromversorgung der Bahnlinien verwendet wird.

In den weiteren abhängigen Ansprüchen sind bevorzugte Weiterbildungen der Erfindung angegeben. So können die Transferfunktionen zwar geeignete nicht-lineare Funktionen sein, auswertungstechnisch ist es jedoch am wenigsten aufwendig, wenn die Transferfunktionen lineare Funktionen mit unterschiedlichen Steigungen sind.

Dabei ist es im Hinblick auf die in der Praxis auftretenden Größenordnungen von Regelbetrieb- und Störströmen von Vorteil, wenn die erste, hoch auflösende Transferfunktion eine Steigung aufweist, die einem Vielfachen, vorzugsweise mindestens dem 5-fachen, besonders bevorzugt etwa dem 10-fachen der Steigung der zweiten, niedrig auflösenden Transferfunktion entspricht.

Gemäß einer weiteren vorteilhaften Ausführungsform der Erfindung kann die hoch auflösende Transferfunktion im Nullpunkt verschoben ausgelegt sein. Dies ist für einen Messverstärker erforderlich, der einen sogenannten Live-Zero-Stromausgang besitzt. Durch diese Maßnahme wird also das Einsatzspektrum der erfindungsgemäßen Überwachungsvorrichtung vergrößert.

Falls messtechnisch notwendig, muss die erfindungsgemäße Einteilung der Transferfunktionen nicht auf jeweils eine Transferfunktion pro Auflösungsbereich beschränkt bleiben. Es kann gemäß einer Weiterbildung der Erfindung vorgesehen sein, dass die Transferfunktionen jeweils aus zwei oder mehreren unterschiedlichen Unter-Transferfunktionen zusammengesetzt sind. Dies erhöht die Variabilität der Verstärkungscharakteristik der Messverstärkerschaltung.

Die Transferfunktionen können ferner zur Ausbildung von positiven und negativen Strömen ausgelegt sein. Damit ist es möglich, auch negative Eingangsspannungen zu verarbeiten und in ihrem Dynamikbereich zu komprimieren. Dieser öffnet die Möglichkeit, auch negative Ströme zu messen, wie sie beispielsweise in Form von negativen Fahrströmen durch Rekuperation bei Bremsvorgängen von in das Netz zurückspeisenden Schienenfahrzeugen auftreten. Auch ermöglichen diese Transferfunktionen dann eine Anwendung im AC-Strombereich, beispielsweise bei AC-Bahnstromversorgungen.

Nach einer weiteren vorteilhaften Ausführungsform der Erfindung ist die Messverstärkerschaltung in an sich bekannter Weise zwischen Eingang und Ausgang potenzialgetrennt ausgelegt. Damit ist gewährleistet, dass gefährlich hohe Spannungen am Shuntwiderstand und damit am Messeingang vom Messsignalausgang und dem Energieversorgungsanschluss ferngehalten werden. Dies kommt der Produktsicherheit der Überwachungsvorrichtung zugute.

Derselben Zielsetzung dient die optionale potenzialtrennende Hilfsenergiezufuhr für die Energieversorgung der Messverstärkerschaltung.

Schließlich kann in die erfindungsgemäße Überwachungsvorrichtung eine Leitungsbruchüberwachung für die Leitungsverbindung zwischen Shuntwiderstand und Messverstärkerschaltung integriert werden, indem dieser Leitungsverbindung und dem Shuntwiderstand vom Messverstärker ein geringer Teststrom eingeprägt wird. Ein Leitungsbruch bringt dann den Messverstärker an seine Aussteuergrenze, was als Fehlerzustand eindeutig erfassbar ist. Die erfindungsgemäße Überwachungsvorrichtung ist damit sicherheitstechnisch weiter optimiert.

Weitere Merkmale, Einzelheiten und Vorteile der Erfindung ergeben sich aus der nachfolgenden Beschreibung eines Ausführungsbeispiels anhand der beigefügten Zeichnungen. Es zeigen:
- Fig. 1: ein Blockschaltbild einer Bahn-Fahrstromversorgung mit einer erfindungsgemäßen Überwachungsvorrichtung,
- Fig. 2: ein detaillierteres Blockschaltbild einer in der Überwachungsvorrichtung verwendeten Messverstärkerschaltung,
- Fig. 3: ein detaillierteres Blockschaltbild der Energieversorgung der Messverstärkerschaltung,
- Fig. 4 und 5: zwei unterschiedliche Strom-Spannungsdiagramme der Kompressionscharakteristik einer in der Überwachungsvorrichtung verwendeten Kompressionsstufe,
- Fig. 6: ein Schaltbild einer Realisierungsmöglichkeit für eine Kompressionsstufe mit zwei Transferfunktionen,
- Fig. 7: ein Zeit-Strom-Diagramm eines Kurzschlussstromes in einem Störzustand, und
- Fig. 8: ein Blockschaltbild einer Bahn-Fahrstromversorgung mit einer Überwachungsvorrichtung nach dem Stand der Technik.

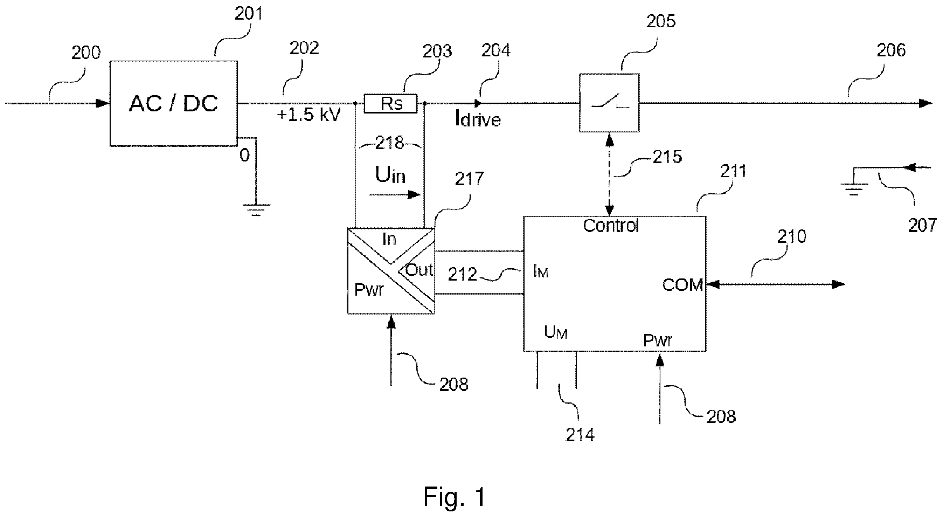

Wie aus Fig. 1 hervorgeht, ist analog der Beschreibung des Standes der Technik oben im einleitenden Teil die Energieversorgung einer Bahnstrecke mit einer Zuführleitung 200, einem geregelten Leistungsgleichrichter 201 und einem Shuntwiderstand 203 in der den zu überwachenden Strom I_{drive} führenden Versorgungsleitung 204 dargestellt. Eine den Spannungsabfall Uᵢₙ am Shuntwiderstand 203 eingangsseitig aufnehmende Messverstärkerschaltung 217 mit einem Gesamt-Dynamikbereich ist vorgesehen, der wiederum Regelbetriebsströme und Störströme abdeckt. Ein das Ausgangssignal (I_{M}) der Messverstärkerschaltung 217 aufnehmendes Schutzgerät 211 dient zum Erfassen dieser Regelbetriebs- und Störströme.

Der Leistungsgleichrichter 201 kann analog dem Stand der Technik einen oder mehrere DC-Ausgänge 202 mit z.B. einer Ausgangsspannung von nominal +1500 V DC besitzen. Dieser Ausgang 202 kann über den Leistungs-Shuntwiderstand 203 den erforderlichen Strom I_{drive} über die Leitung 204 an den Leistungsschalter bzw. Stromunterbrecher 205 liefern. Der Shuntwiderstand 203 kann auch hinter dem Stromunterbrecher 205 angeordnet sein.

Der Stromunterbrecher 205 wird elektrisch vom sogenannten Schutzgerät 211 (Protection Relay) über die Steuerleitungen 215 gesteuert, die mit dem Anschluss Control verbunden sind. Diese Steuerleitungen 215 melden auch die jeweils herrschende Schalterstellung an das Schutzgerät 211 über den Anschluss Control zurück. Der Stromunterbrecher 205 besitzt eigene elektromagnetische Auslösemittel, die bei sehr großen Überströmen den Leistungsschalter selbsttätig öffnen, also ohne Öffnungsbefehl vom Schutzgerät 211 den Stromkreis unterbrechen. Dies bringt zusätzliche Sicherheit im Falle eines Fehlers des Schutzgerätes.

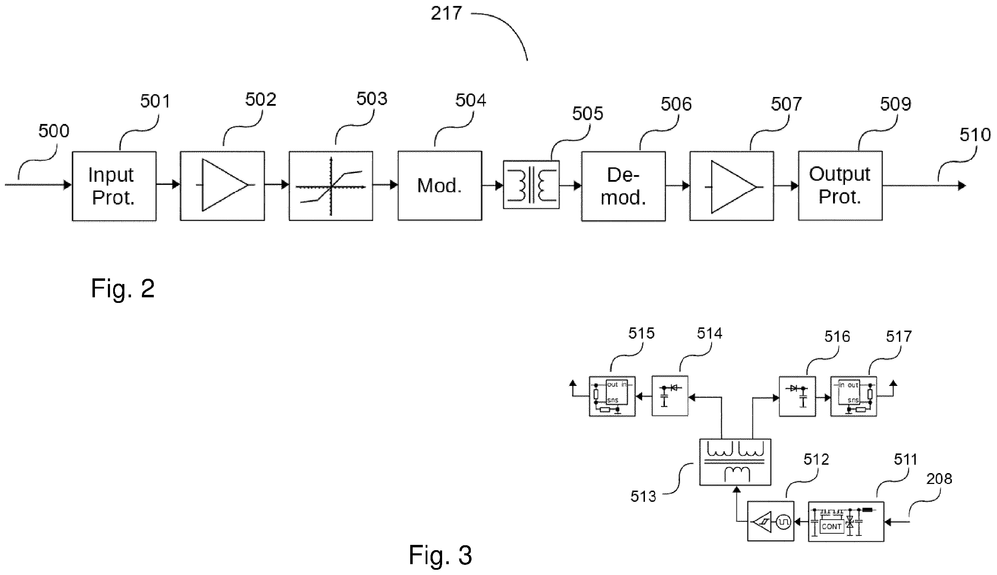

Im Gegensatz zum Stand der Technik benötigt - wie aus den Fig. 1 und 2 hervorgeht - die erfindungsgemäße Messverstärkerschaltung 217 nur noch einen potenzialtrennenden Messverstärker für die Shuntspannung Uᵢₙ und demzufolge auch das Schutzgerät 211 nur noch einen Messkanal I_{M} für den Strom. Trotzdem kann mit dieser stark reduzierten und dadurch deutlich preiswerteren Anordnung sowohl der Fahrstrom als auch ein Kurzschlussstrom ausreichend genau vom Schutzgerät 211 erfasst werden, wie aus der nachfolgenden Beschreibung deutlich wird.

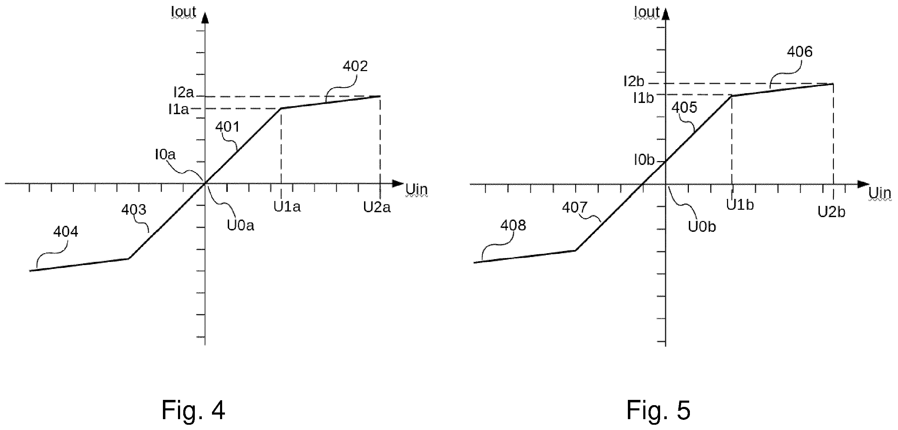

Das Messsignal 500 (Fig. 2) gelangt auf ein Eingangsschutznetzwerk 501, das auch Mittel zur Realisierung einer Leitungsbruchüberwachung für die Leitungen 218 zum Shuntwiderstand 203 aufweisen kann, dann auf einen Messverstärker 502, der die gesamte Messdynamik des Eingangssignals linear, aber verstärkt abbilden kann, dann auf eine Kompressionsstufe 503, die beispielsweise mit einer vierteiligen Transferfunktion nach Fig. 4 arbeitet und schließlich auf einen Modulator 504, der das komprimierte Ausgangssignal des Messverstärkers 502 so moduliert, dass es über eine Potenzialbarriere 505 (zum Beispiel einen Transformator) übertragen werden kann. Das Ausgangssignal der Potenzialbarriere wird einem Demodulator 506 eingespeist, der das ursprüngliche, komprimierte Signal wieder zurückgewinnt. Dieses wird auf einen Ausgangsverstärker 507 gegeben, der beispielsweise als Stromausgang ausgebildet ist.

Von dort wird über das Ausgangsschutznetzwerk 509 der Ausgang 510 gespeist. An Stelle der Potenzialbarriere 505 in Form eines Transformators können auch andere Potenzialbarrieren wie Optokoppler, kapazitive Koppler, induktive Koppler, magnetoresistive Koppler oder Piezokoppler in jeglicher Form verwendet werden.

Der Ausgangsverstärker 507 kann auch als Spannungsausgang oder als Stromausgang mit anderen Wertebereichen wie oben angegeben ausgelegt sein.

Die Energieversorgung der Messverstärkerschaltung 217 erfolgt über eine in Fig. 1 gezeigte Hilfsenergiezuleitung 208 und ist anhand von Fig. 3 -näher zu erläutern. Die über die Hilfsenergiezuleitung 208 eingespeiste Spannung (z.B. eine DC-Spannung) wird über ein Schutznetzwerk 511 und einen ggf. geregelten Zerhacker 512 auf den in der Messverstärkerschaltung 217 integrierten Transformator 513 gegeben. Dessen potenzialgetrennte Ausgangsspannungen werden über die beiden Ausgangswicklungen des Transformators 513 und jeweils Gleichrichtern 514, 516 sowie Spannungsreglern 515 und 517 für die Eingangssektion und Ausgangssektion der Messverstärkerschaltung 217 gewonnen.

Die Übertragungscharakteristik der Kompressionsstufe 503, die für eine die Dynamik der Eingangsspannung komprimierende Funktion in der Messverstärkerschaltung 217 sorgt, ist nun anhand der Fig. 4 zu erläutern. Diese Übertragungscharakteristik zeigt die Form einer abknickenden Übertragungskennlinie, die aus abschnittsweise linearen Transferfunktionen mit unterschiedlichen Steigungen zusammengesetzt ist.

So lässt sich also gemäß Fig. 4 die Übertragungskennlinie für positive Eingangsspannungen in zwei Abschnitte aufteilen. Die jeweilige zum Abschnitt zugehörige Transferfunktion ist nur für den jeweiligen Kurvenabschnitt gültig. Diese Transferfunktionen sind also nur dann individuell im Eingriff, wenn die Spannung Uᵢₙ in dem jeweiligen angegebenen Bereich liegt.

Ein erster Abschnitt 401 hat eine Transferfunktion ${tf}_{401} \left({U}_{in}\right) = {c}_{0} + {c}_{1} * {U}_{in}$
wobei c₀ = 0 und c₁= (T₁ₐ-I₀ₐ)/(U₁ₐ-U₀ₐ).
tf₄₀₁ kommt zum Eingriff, wenn U₀ₐ ≤ Uᵢₙ ≤ U₁ₐ ist.

Ein zweiter Abschnitt 402 hat eine Transferfunktion ${tf}_{402} \left({U}_{in}\right) = {d}_{0} + {d}_{1} * \left({U}_{in}-{U}_{1 a}\right)$
wobei d₀=I₁ₐ und d₁=(I₂ₐ-I₁ₐ)/(U₂ₐ-U₁ₐ).
tf₄₀₂ kommt zum Eingriff, wenn U₁ₐ < Uᵢₙ ist.

Im Diagramm gemäß Fig. 4 ist klar erkennbar, dass c₁ deutlich größer als d₁ ist, und zwar ca. um den Faktor k = 10.

Es versteht sich, dass im Falle einer rein analog elektronischen Realisierung die Kompressionsstufe 503 mit ihren Transferfunktionen wie 401 und 402 mit gewissen Unschärfen behaftet sein kann, in diesem Sinne können die "Knickpunkte" mehr oder weniger scharf ausgebildet sein.

Es versteht sich ebenfalls, dass für die Verarbeitung negativer Spannungen Uᵢₙ dann weitere Transferfunktionen tf₄₀₃ und tf₄₀₄ zur Wirkung kommen.

Insbesondere durch die Kompressionsstufe 503 mit den beschriebenen Transferfunktionen ist es möglich, den gleichen Dynamikbereich für Uᵢₙ zu verarbeiten, für den vorher die beiden konventionellen Messverstärker 109 und 110 (oder ein zweikanaliger Messverstärker 117) sowie zwei Messkanäle im Schutzgerät 111 erforderlich waren. Durch die Dynamikkompression der Messverstärkerschaltung 217 wird zwar die erzielbare Auflösung insbesondere für den Kurzschlussstrombereich etwas verringert, jedoch ist dies für die Verschleißerkennung des Stromunterbrechers 205 nicht von Bedeutung. Wichtig ist, dass die hohe Auflösung für den regulären Fahrstrom genügend groß bleibt. Es ist dabei zu erwähnen, dass der maximale Ausgangsstrombereich der Messverstärkerschaltung 217 auch über die üblichen 20 mA hinausgehen kann. Äquivalentes gilt für ggf. zum Einsatz kommende Spannungsausgänge anstelle der Stromausgänge.

Das Diagramm in Fig. 5 zeigt eine im Nullpunkt verschobene Transferfunktion mit den Abschnitten 405 und 406. Dies ist z.B. dann erforderlich, wenn die Messverstärkerschaltung 217 einen sogenannten Live-Zero-Stromausgang besitzt. Für positive Eingangsspannungen Uᵢₙ ist dann sichergestellt, dass auch bei einer Eingangsspannung von 0 mV am Stromausgang schon ein Strom von z.B. 4 mA an den Eingang 212 des Messkanals I_{M} geliefert wird. Hier ist also der Koeffizient c₀ größer als Null.

In den Diagrammen zur Transferfunktion gemäß den Fig. 4 und 5 ist anhand der Abschnitte 403, 404, 407, 408 erkennbar, dass auch negative Eingangsspannungen verarbeitet und ebenfalls in ihrer Dynamik komprimiert werden können. Somit können auch negative Ströme gemessen werden. Negative Fahrströme können beispielsweise durch Rekuperation auftreten, also bei in das Netz rückspeisenden Schienenfahrzeugen während Bremsvorgängen. Außerdem sind durch diese für negative Eingangsspannungen wirksamen Transferfunktionen auch AC-Stromerfassungen möglich, z.B. für AC-Bahnen oder AC-Antriebe.

Es sei klargestellt, dass die Dynamik-komprimierende Funktion der Messverstärkerschaltung 217 nicht nur mit Kompressionsstufen 503 mit Kennlinien gemäß Fig. 4 und 5 möglich ist, sondern auch mit anderen, noch mehr Einzelabschnitte umfassenden Transferfunktionen realisierbar ist. Auch ist es nicht unbedingt erforderlich, auf lineare Funktionen zurückzugreifen. So können auch Kurven oder Kombinationen linearer Abschnitte mit Kurven geeignet sein. Wichtig ist, dass das Schutzgerät 211 an seinem Messkanal 212 Werte gewinnen kann, die eineindeutig einer konkreten Eingangsspannung und damit eindeutig einem konkreten Strom zuzuordnen sind. Die Messverstärkerschaltung 217 darf also keine mehrdeutigen Messsignale liefern. Die abschnittsweisen Transferfunktionen (bzw. gleitenden Transferfunktionen in Form von Kurven) müssen natürlich in jedem Falle dem Schutzgerät 211 "bekannt sein".

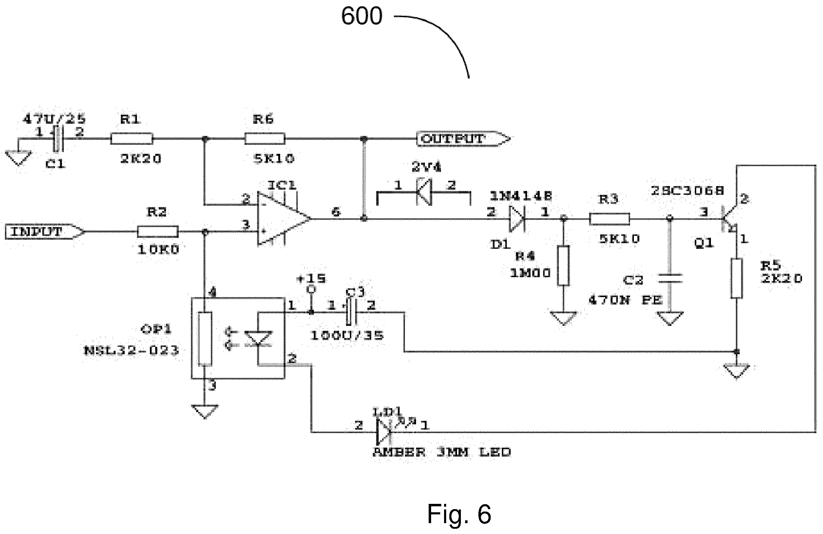

Mögliche elektronische Schaltungen für die Realisierung der Kompressionsstufe 503 sind in der Literatur grundsätzlich bekannt. Ein mögliches Grundprinzip ist beispielsweise in einem Schaltungsvorschlag 600 gemäß Fig. 6 aus einem Applikationsbericht "Compressor Applications for Resistive Optocouplers" der Firma Silonex angegeben. Außerdem gibt es ähnliche Schaltungen, die statt des hier verwendeten speziellen Optokopplers mit Feldeffekttransistoren arbeiten.

Auch eine Realisierung der Kompressionsstufe 503 mit Hilfe digitaler Signalverarbeitung ist zwar möglich, allerdings ist dies nicht bevorzugt, denn dies würde eine aufwendige Digitalisierung der Spannung Uᵢₙ bereits im Messverstärker erfordern, was der Zielsetzung der Erfindung an sich widerspricht.

Grundsätzlich wäre es schließlich ebenfalls möglich, die Kompressionsstufe 503 an beliebiger Stelle im Signalpfad anzuordnen, beispielsweise hinter dem Demodulator 506, was allerdings aus Gründen der beschränkten Dynamik des Modulators/Demodulators nicht optimal wäre. Auch eine Positionierung vor dem ersten Messverstärker 502 wäre aufgrund der Toleranzen der Kennlinien keine vernünftige Alternative.

Ebenso ist es möglich, auf die Potenzialtrennung zwischen der ausgangsseitigen Elektronik (506, 507, 509, 510) und der Hilfsenergie (208, 511, 512) zu verzichten. Der Transformator 513 enthält dann eine Wicklung weniger, die Blöcke 516 und 517 können auch entfallen. Die Potenzialtrennung der eingangsseitigen Elektronik (500, 501, 502, 503, 504, 514,515) gegenüber der ausgangsseitigen Elektronik (506, 507, 509, 510, ggf. 517) und der Hilfsenergieversorgung (208, 511, 512) bleibt erhalten.

## Patentansprüche

1. Überwachungsvorrichtung für hochdynamische Ströme, insbesondere für die Überwachung von Bahnströmen, Antriebsströmen von Anlagen und dergleichen, umfassend
- einen Shuntwiderstand (203) in der den zu überwachenden Strom (I_{drive}) führenden Versorgungsleitung (204),
- eine den Spannungsabfall (Uᵢₙ) am Shuntwiderstand (203) eingangsseitig aufnehmende Messverstärkerschaltung (217) mit einem Gesamt-Dynamikbereich, der Regelbetriebsströme und Störströme abdeckt, und
- ein das Ausgangssignal (I_{M}) der Messverstärkerschaltung (217) aufnehmendes Auswertegerät zum Erfassen von Regelbetriebs- und Störströmen, wobei
- die Messverstärkerschaltung (217) eine einkanalige Messverstärkerschaltung (217) ist, mit
= einem den Gesamt-Dynamikbereich der Eingangsspannung (Uᵢₙ) abbildenden Messverstärker (502) und **gekennzeichnet durch**
= eine das Ausgangssignal des Messverstärkers (502) aufnehmende Kompressionsstufe (503) mit mindestens zwei unterschiedlichen Transferfunktionen (tf₄₀₁, tf₄₀₂), von denen eine erste Transferfunktion (tf₄₀₁) den Messbereich der Regelbetriebsströme hoch aufgelöst und von denen die zweite, die Dynamik der Eingangsspannung komprimierende Transferfunktion (tf₄₀₂) den Messbereich der Störströme niedriger aufgelöst in das Ausgangssignal (I_{M}) der Messverstärkerschaltung (217) wandelt.

2. Überwachungsvorrichtung nach Anspruch 1, **dadurch gekennzeichnet, dass** das Auswertegerät ein Schutzgerät (211) für Bahnstromanwendungen ist.

3. Überwachungsvorrichtung nach Anspruch 1 oder 2, **dadurch gekennzeichnet, dass** die Transferfunktionen (tf₄₀₁, tf₄₀₂) jeweils lineare Funktionen mit unterschiedlichen Steigungen (c₁, d₁) sind.

4. Überwachungsvorrichtung nach Anspruch 3, **dadurch gekennzeichnet, dass** die erste, hoch auflösende Transferfunktion (tf₄₀₁) eine Steigung (c₁) aufweist, die einem Vielfachen der Steigung (d₁) der zweiten, niedrig auflösenden Transferfunktion (tf₄₀₂) entspricht.

5. Überwachungsvorrichtung nach Anspruch 4, **dadurch gekennzeichnet, dass** die Steigung (c₁) der ersten, hoch auflösenden Transferfunktion (tf₄₀₁) mindestens dem 5-fachen, insbesondere etwa dem 10-fachen, der Steigung (d₁) der zweiten, niedrig auflösenden Transferfunktion (tf₄₀₂) entspricht.

6. Überwachungsvorrichtung nach einem der vorgenannten Ansprüche, **dadurch gekennzeichnet, dass** die Überwachungsvorrichtung zum Überwachen von Bahnströmen und/oder Antriebsströmen von Anlagen ausgebildet ist.

7. Überwachungsvorrichtung nach einem der vorgenannten Ansprüche, **dadurch gekennzeichnet, dass** die hoch auflösende Transferfunktion (tf₄₀₁) im Nullpunkt verschoben ausgelegt ist.

8. Überwachungsvorrichtung nach einem der vorgenannten Ansprüche, **dadurch gekennzeichnet, dass** die Transferfunktionen (tf₄₀₁, tf₄₀₂) aus zwei oder mehreren unterschiedlichen Unter-Transferfunktionen zusammengesetzt sind.

9. Überwachungsvorrichtung nach einem der vorgenannten Ansprüche, **dadurch gekennzeichnet, dass** die Transferfunktionen (tf₄₀₁, tf₄₀₂, tf₄₀₃, tf₄₀₄) zur Abbildung von positiven und negativen Strömen ausgelegt sind.

10. Überwachungsvorrichtung nach einem der vorgenannten Ansprüche, **dadurch gekennzeichnet, dass** die Messverstärkerschaltung (217) zwischen Eingang (500) und Ausgang (510) potenzialgetrennt ausgelegt ist.

11. Überwachungsvorrichtung nach einem der vorgenannten Ansprüche, **dadurch gekennzeichnet, dass** die Energieversorgung der Messverstärkerschaltung (217) über eine potenzialtrennende Hilfsenergiezufuhr (208) erfolgt.

12. Überwachungsvorrichtung nach einem der vorgenannten Ansprüche, **dadurch gekennzeichnet, dass** zur Realisierung einer Leitungsbruchüberwachung der Leitungsverbindung (218) zwischen Shuntwiderstand (203) und Messverstärkerschaltung (217) vom Messverstärker (502) ein geringer Teststrom in die Leitungsverbindung (218) und über den Shuntwiderstand (203) einprägbar ist.

## Claims

1. Monitoring apparatus for wide-dynamic-range currents, in particular for monitoring traction currents, drive currents of installations and the like, comprising
- a shunt resistor (203) in the supply line (204) carrying the current (I_{drive}) to be monitored,
- a measurement amplifier circuit (217), the input side of which receives the voltage drop (Uᵢₙ) across the shunt resistor (203), with an overall dynamic range that covers normal-operation currents and fault currents, and
- an evaluation device that receives the output signal (I_{M}) of the measurement amplifier circuit (217), to record normal-operation and fault currents,
**wherein**
- the measurement amplifier circuit (217) is a single-channel measurement amplifier circuit (217) comprising
= a measurement amplifier (502) that covers the overall dynamic range of the input voltage (Uᵢₙ), and **characterized by**
= a compression stage (503), which receives the output signal of the measurement amplifier (502), having at least two different transfer functions (tf₄₀₁, tf₄₀₂), a first transfer function (tf₄₀₁) of which converts the measurement range of the normal-operation currents at high resolution and the second transfer function (tf₄₀₂) of which, which compresses the dynamic range of the input voltage, converts the measurement range of the fault currents at lower resolution into the output signal (I_{M}) of the measurement amplifier circuit (217).

2. Monitoring apparatus according to Claim 1, **characterized in that** the evaluation device is a protective device (211) for traction power applications.

3. Monitoring apparatus according to Claim 1 or 2, **characterized in that** the transfer functions (tf₄₀₁, tf₄₀₂) are each linear functions having different gradients (c₁, d₁).

4. Monitoring apparatus according to Claim 3, **characterized in that** the first, high-resolution transfer function (tf₄₀₁) has a gradient (c₁) that corresponds to a multiple of the gradient (d₁) of the second, low-resolution transfer function (tf₄₀₂).

5. Monitoring apparatus according to Claim 4, **characterized in that** the gradient (c1) of the first, high-resolution transfer function (tf₄₀₁) corresponds to at least 5 times, particularly to approximately 10 times, the gradient (d1) of the second, low-resolution transfer function (tf₄₀₂).

6. Monitoring apparatus according to one of the preceding claims, **characterized in that** the monitoring apparatus is designed for monitoring traction currents and/or drive currents of installations.

7. Monitoring apparatus according to one of the preceding claims, **characterized in that** the high-resolution transfer function (tf₄₀₁) is designed so as to be shifted at the origin.

8. Monitoring apparatus according to one of the preceding claims, **characterized in that** the transfer functions (tf_{401,} tf₄₀₂) are made up of two or more different sub-transfer functions.

9. Monitoring apparatus according to one of the preceding claims, **characterized in that** the transfer functions (tf_{401,} tf₄₀₂, tf₄₀₃, tf₄₀₄) are designed to reproduce positive and negative currents.

10. Monitoring apparatus according to one of the preceding claims, **characterized in that** the measurement amplifier circuit (217) is designed to have potential isolation between the input (500) and the output (510).

11. Monitoring apparatus according to one of the preceding claims, **characterized in that** power is supplied to the measurement amplifier circuit (217) by way of a potential-isolating auxiliary power supply (208).

12. Monitoring apparatus according to one of the preceding claims, **characterized in that** cable break monitoring for the cable connection (218) between shunt resistor (203) and measurement amplifier circuit (217) is accomplished by virtue of the measurement amplifier (502) being able to impress a low test current into the cable connection (218) and via the shunt resistor (203).

## Revendications

1. Dispositif de surveillance pour des courants hautement dynamiques, en particulier pour la surveillance de courants de traction, de courants d'entraînement d'installations et analogue, comprenant :
- une résistance de shunt (203) dans la ligne d'alimentation (204) conduisant le courant à surveiller (I_{drive}),
- un circuit d'amplification de mesure (217) recevant, côté entrée, la chute de tension (Uᵢₙ) au niveau de la résistance de shunt (203), avec une plage dynamique complète qui couvre des courants de fonctionnement normal et des courants parasites, et
- un appareil d'évaluation recevant le signal de sortie (I_{M}) du circuit d'amplification de mesure (217) pour détecter des courants de fonctionnement normal et des courants parasites,
dans lequel
- le circuit d'amplification de mesure (217) est un circuit d'amplification de mesure à canal unique (217), comportant
= un amplificateur de mesure (502) reproduisant la plage dynamique complète de la tension d'entrée (U_{M}) et **caractérisé par**
= un étage de compression (503) recevant le signal de sortie de l'amplificateur de mesure (502) avec au moins deux fonctions de transfert différentes (tf₄₀₁, tf₄₀₂), dont une première fonction de transfert (tf₄₀₁) convertit la plage de mesure des courants de fonctionnement normal à une résolution élevée, et dont la seconde fonction de transfert (tf₄₀₂) compressant la dynamique de la tension d'entrée convertit la plage de mesure des courants parasites en signal de sortie (I_{M}) du circuit d'amplification de mesure (217) à une résolution plus basse.

2. Dispositif de surveillance selon la revendication 1, **caractérisé en ce que** l'appareil d'évaluation est un appareil de protection (211) pour des applications de courant de traction.

3. Dispositif de surveillance selon la revendication 1 ou 2, **caractérisé en ce que** les fonctions de transfert (tf₄₀₁, tf₄₀₂) sont respectivement des fonctions linéaires avec différents gradients (c₁, d₁).

4. Dispositif de surveillance selon la revendication 3, **caractérisé en ce que** la première fonction de transfert à haute résolution (tf₄₀₁) présente un gradient (c₁) qui correspond à un multiple du gradient (d₁) de la seconde fonction de transfert à basse résolution (tf₄₀₂).

5. Dispositif de surveillance selon la revendication 4, **caractérisé en ce que** le gradient (c₁) de la première fonction de transfert à haute résolution (tf₄₀₁) correspond à au moins 5 fois, en particulier à environ 10 fois, le gradient (d₁) de la seconde fonction de transfert à faible résolution (tf₄₀₂).

6. Dispositif de surveillance selon l'une des revendications précédentes, **caractérisé en ce que** le dispositif de surveillance est conçu pour surveiller des courants de traction et/ou des courants d'entraînement d'installations.

7. Dispositif de surveillance selon l'une des revendications précédentes, **caractérisé en ce que** la fonction de transfert à haute résolution (tf₄₀₁) est conçue de manière décalée à l'origine.

8. Dispositif de surveillance selon l'une des revendications précédentes, **caractérisé en ce que** les fonctions de transfert (tf₄₀₁, tf₄₀₂) sont composées de deux ou plusieurs sous-fonctions de transfert différentes.

9. Dispositif de surveillance selon l'une des revendications précédentes, **caractérisé en ce que** les fonctions de transfert (tf₄₀₁, tf₄₀₂, tf₄₀₃, tf₄₀₄) sont conçues pour reproduire des courants positifs et négatifs.

10. Dispositif de surveillance selon l'une des revendications précédentes, **caractérisé en ce que** le circuit d'amplification de mesure (217) est conçu avec une coupure de potentiel entre l'entrée (500) et la sortie (510).

11. Dispositif de surveillance selon l'une des revendications précédentes, **caractérisé en ce que** l'alimentation en énergie du circuit d'amplification de mesure (217) s'effectue par un apport d'énergie auxiliaire à coupure de potentiel (208).

12. Dispositif de surveillance selon l'une des revendications précédentes, **caractérisé en ce que**, pour réaliser une surveillance de rupture de câble de la connexion par câble (218) entre la résistance de shunt (203) et le circuit d'amplification de mesure (217), un faible courant de test peut être appliqué par l'amplificateur de mesure (502) dans la connexion par câble (218) et à travers la résistance de shunt (203).
